# EUROPEAN PATENT SPECIFICATION

(11) **EP 2 048 452 B1**
(45) Date of publication and mention of the grant of the patent: **27.10.2010**
(21) Application number: 08008488.2
(22) Date of filing: 06.05.2008
(51) Int. Cl.: F24J 2/04, E04D 13/08, F03D 3/02, F03D 3/04, F03D 9/00, H01L 31/048, H01L 31/058

(54) **Roof based energy conversion system**
Dach-Energieumwandlungssystem
Système de conversion d'énergie basé sur le toit

(30) Priority: 09.10.2007 SG 200716873
(43) Date of publication of application: 15.04.2009
(73) Proprietor: Dragon Energy Pte. Ltd., Singapore 048623 (SG)
(72) Inventor: Nightingale, Christopher George Edward, 259983 Singapore (SG)
(74) Representative: Hasler, Erich

(56) References cited:
- EP-A- 1 201 842
- WO-A-00/77860
- WO-A-02/101839
- WO-A-2006/082399
- WO-A-2007/007103
- DE-A1- 2 818 475
- DE-A1- 19 644 890
- DE-U1- 29 711 026
- DE-U1- 29 913 860
- GB-A- 2 429 343
- GB-A- 2 435 483

## Description

### Field of the Invention

The present invention relates to a roof based energy conversion system for a building, and in particular to a roof based renewable or alternate energy conversion system.

### Background of the Invention

The potential environmental, economic and cultural dangers arising from the use of fossil fuels to power energy converting devices and systems such as vehicle engines and power stations are well documented. In order to reduce or avoid these dangers, some advocate the increased use of nuclear power. However this creates other dilemmas relating to the safe storage of radioactive waste. In addition, nuclear power stations are opposed by many people and Governments due to the potential for their byproducts to be used in the construction of nuclear weapons.

Attempts have been made to develop power stations based on clean alternate energy sources and/or energy conversion systems such as geothermal energy plants, wind farms and large solar arrays. However many of these systems are limited in that they are only commercially viable in certain geographical locations and require relatively high capital investment.

The GB 2435483 describes a solar roof tile which predominantly is for the purposes of heating water. The tile may also carry a photovoltaic cell to generate electricity. The roof tile is generally of an elongated construction having a length that is a multiple width of a standard roof tile. The tile comprises a front coverplate member forming a frame for a transparent window and an elongated trough which houses a heat exchanger having conduits through which water can flow. A disadvantage of the tile is that the construction to mount the transparent window on the cover plate is complex.

In the WO 02/101839 a photovoltaic tile comprises an outer panel and a support structure. The support structure is provided with a socket and a peripheral lower frame member. The outer panel is coupled by angled feet that are received in keyhole slots formed on the support structure. It is disadvantageous that the outer panel has to be lifted to gain access to electrical sockets mounted on the support structure.

The EP 1201842 shows a roof tile comprising a base or main body made from cement and formed with a recess for seating a photovoltaic module. The recess is provided with a further recess for receiving a terminal box provided on an underside of the photovoltaic module. Since the main body is made from cement it is expensive to provide above mentioned recesses, which have to be manufactured very exactly.

The DE 28 18 475 discloses solar heating tiles for heating water. The solar tiles have a recess for seating pipes through which water passes. The solar heating tiles are not designed for implementing photovoltaic cells.

### Summary of the Invention

According to one aspect of the present invention there is provided a roof based energy conversion system according to claim 1.

The plurality of solar energy converting tiles may comprise either (a) one or more photovoltaic tiles that convert solar energy to electrical energy; or, (b) a combination of at least one photovoltaic tile and at least one thermal tile that converts solar energy to thermal energy. The base tiles may be configured or otherwise formed to provide thermal insulation to the roof structure.

The roof frame structure may comprise a pitched roof frame structure having at least two sloping sides that converge toward each other in an upward direction.

The cover tiles for both the photovoltaic tiles and the thermal tiles may be formed so as to have respective exposed surfaces that are of substantially identical appearance. In this way, visually the photovoltaic tiles and the thermal tiles when fixed to a roof frame structure have the same appearance.

The energy conversion system may further comprise a hydro-electric system configured to convert kinetic energy from rain flowing off the portion of the roof to electrical energy. The hydro-electric system may comprise one or more gutters and downpipes; and, one or more water turbines wherein the gutters and downpipes are arranged to collect rain flowing off the portion of the roof frame structure to produce a water flow that drives the or each water turbine. It is envisaged that an upper end of one or more of the down pipes is provided with a reservoir to regulate the flow of water to an associated turbine. One or more roof channels may be provided which are disposed diagonally across the roof leading to the gutters. The hydro-electric system may further comprise storage tanks to collect rainwater for use in the overall energy conversion system or in the building's water system.

The energy conversion system may further comprise a wind power system having one or more wind turbines supported by the roof frame structure which convert kinetic energy of a moving air mass to electrical energy. In this embodiment, the wind power system may further comprise a cowling or sub-roof that overlies the one or more wind turbines to create, together with the roof frame structure, a wind tunnel that directs moving air to flow up the roof frame structure through the one or more wind turbines. The wind turbines may be mounted along a crest of the roof frame structure.

The energy conversion system may further comprise an energy management system which receives and manages the electrical energy from the solar energy converting tile, hydro-electric system and the wind power system. Further, the energy management system may comprise a connection to an electricity supply grid and is configured to manage two way flow of electrical energy between the energy conversion system and the supply grid. More particularly, the energy management system may comprise an electrical energy storage apparatus, the energy management system being configured to provide electrical energy to the supply grid when the electricity storage apparatus is in a fully charged state, and connects the supply grid to the electricity storage apparatus when the electricity storage apparatus has a charge level below a threshold level. The energy management system may further comprise apparatus to measure, control and ensure safety of the energy inputs and to invert the electricity supply to provide from the electricity storage apparatus, an alternating current.

### Brief Description of the Drawings

An embodiment of the present invention will now be described by way of example only with reference to the accompanying drawings in which:
Figure 1 is a section view of a building incorporating a roof based energy conversion system in accordance with an embodiment the present invention;
Figure 2 is a partial side view of the building depicted in Figure 1;
Figure 3 is a section view of a base tile of a photovoltaic tile assembly incorporated in the roof based energy conversion system shown in Figures 1 and 2;
Figure 4 is a top elevation view of the base tile shown in Figure 3;
Figure 5 is a section view of a cover tile incorporated in the photovoltaic tile assembly;
Figure 6 is a top elevation view of the cover tile shown in Figure 5;
Figure 7 is a lateral section view of the photovoltaic tile assembly;
Figure 8 is a transverse section view of the photovoltaic tile assembly;
Figure 9 is a schematic representation of an electrical connection post incorporated in the photovoltaic tile assembly;
Figure 10 is a perspective view of an electrical connection tube incorporated in the photovoltaic tile assembly;
Figure 11 is a plan view of the tube shown in Figure 10;
Figure 12 is a section view of a tube shown in Figures 10 and 11;
Figure 13 is a section view of a portion of a cover tile shown in Figures 5 and 6;
Figure 14 is a schematic representation of an embodiment of a hydroelectric system incorporated in the roof based energy conversion system shown in Figures 1 and 2;
Figure 15 is a top elevation view of a down pipe incorporated in the hydroelectric system shown in Figure 14;
Figure 16 is a side elevation view of the hydroelectric system;
Figure 17 is an end view of a wind energy conversion system incorporated in the roof based energy conversion system shown in Figures 1 and 2; and,
Figure 18 is a partial side view of the system shown in Figure 17.

### Detailed Description of Preferred Embodiments

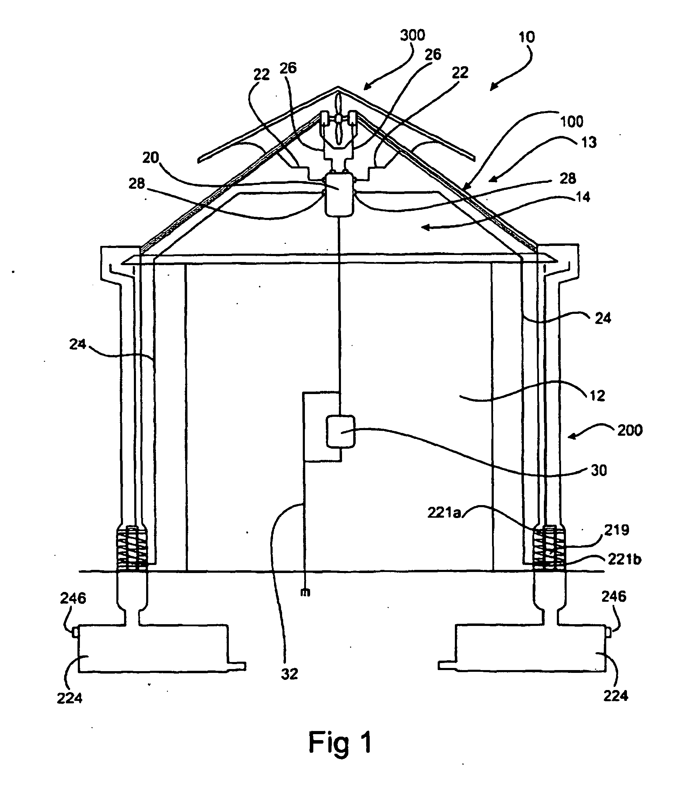

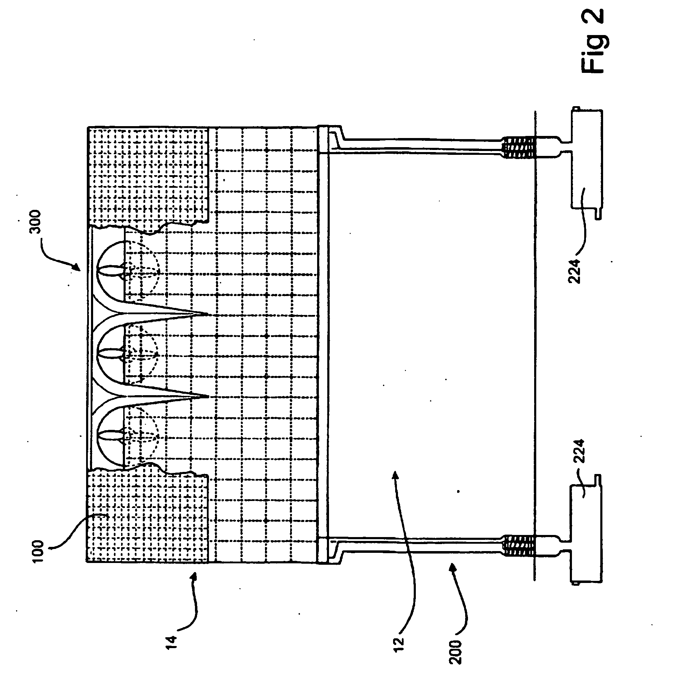

Referring to Figures 1 and 2 a roof based energy conversion system 10 for a building, such as a house 12 with a roof 13, comprises a roof frame structure 14 and a plurality of solar energy converting tile assemblies. Each tile assembly comprises a base tile that is fixed to at least a portion of the roof frame structure 14, and one or more cover tiles attachable to a corresponding base tile. The base tiles are configured to sealingly engage each other along adjacent edges so as to form a substantially waterproof cladding for the portion of the roof structure to which they are fixed. As explained in greater detail below, the tile assemblies may be selected from photovoltaic (PV) tile assemblies 100 that convert solar energy into electrical energy and thermal tile assemblies (not shown) that convert solar energy to thermal energy. The thermal tile may comprise pipes through which water flows, the tiles absorbing solar radiation to heat the water flowing through the pipes. Both types of tiles have a base tile of similar general construction and configuration. It is further envisaged that the respective cover tiles will have the same shape, configuration and exterior appearance so as to be visually indistinguishable when laid together on the same roof frame structure 14. However the construction of the cover tiles will be different for the PV tiles and the thermal tiles in order to accommodate the different tasks of converting solar energy to electricity and heat. In different embodiments the system 10 may incorporate either only the PV tiles or a combination of both PV tiles and thermal tiles.

It is envisaged when the system 10 comprises both PV tiles and thermal tiles, that the PV tiles will be laid on upper portions of the roof 13 to benefit from wind cooling and higher exposure thereby facilitating optimum efficiency in the generation of electricity. Naturally if the system 10 incorporates only the PV tiles, then these tiles may be laid over the entire exposed areas of the roof 13, or if only a limited number of PV tiles are used, then such tiles should, as mentioned above, be laid on the upper portions of the roof 13.

The PV tile assemblies 100 are described in greater detail later.

The energy conversion system 10 can also incorporate a hydro-electric system 200 that is configured to convert kinetic energy from rain running off the roof structure 14 to electrical energy. The hydro-electric system 200 is described in detail below.

Further, the system 10 may also incorporate a wind energy conversion system 300 that converts kinetic energy of moving air (ie wind) to electrical energy.

The energy conversion system 10 further includes an energy management system 20 which receives the electrical energy generated by the PV tiles 100 via cables 22, the hydro-electric system 200 via cables 24 and the wind energy conversion system 300 via cables 26. It is envisaged that the energy management system 20 will include a plurality of input jacks 28 into which electric cables providing output current from the various energy conversion assemblies and systems 100, 200 and 300 can be plugged. The energy management system 20 may incorporate an electrical energy storage device such as rechargeable batteries for storing electricity generated by the various energy conversion systems. The energy management system 20 may also include a connection system 30 with cable 32 to connect to an electricity supply grid and a controller to manage two way flow of electricity between the batteries and the supply grid. In this way, the system 10 can feed electricity to the supply grid when, for example, the batteries are fully charged, and, can draw electricity from the supply grid when the level of charge in the batteries is below a predetermined level. Naturally, the energy management system will also include converters and inverters to convert DC to AC and AC to DC, firstly to convert the type of current produced by the energy conversion systems, where necessary from AC to DC to enable storage in the batteries, and secondly to allow transfer of electricity from the batteries to either the supply grid or to power points and appliances within the building which would typically operate on AC.

### Photovoltaic Tile Assemblies 100

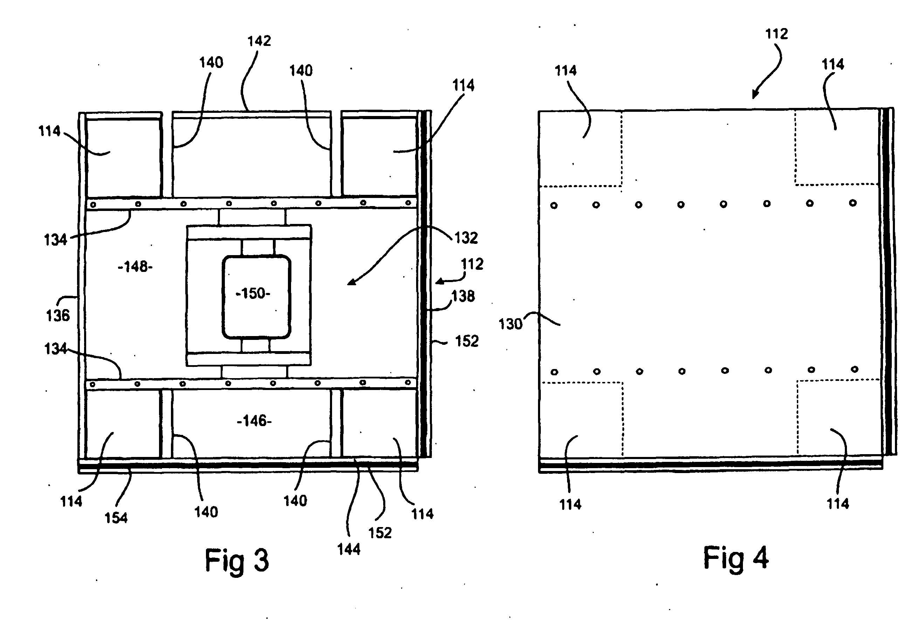

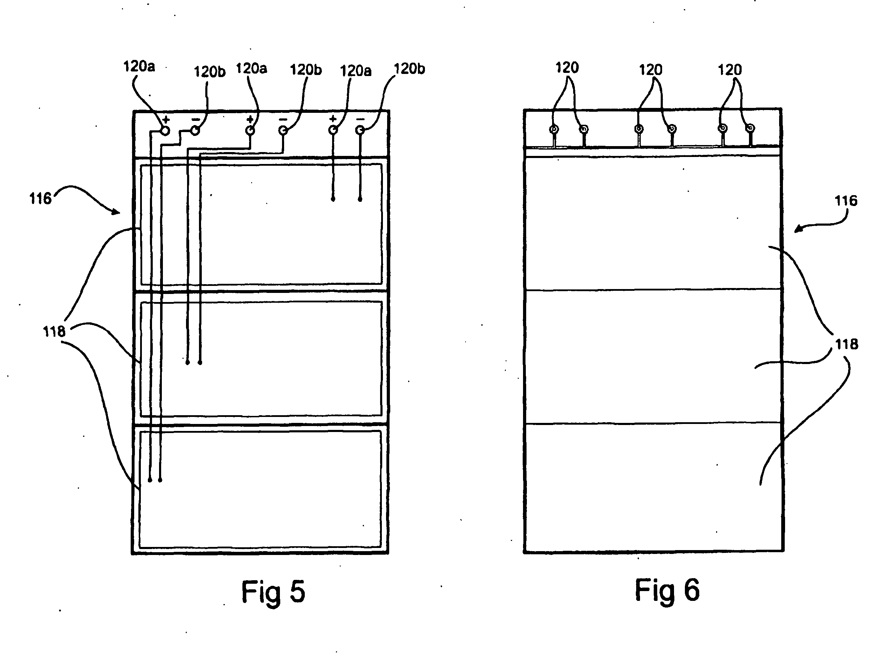

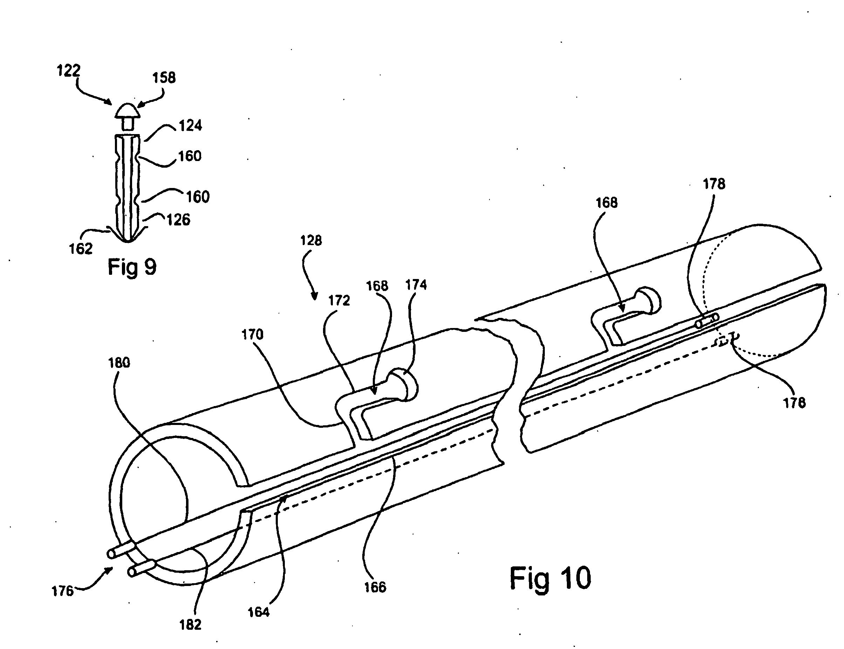

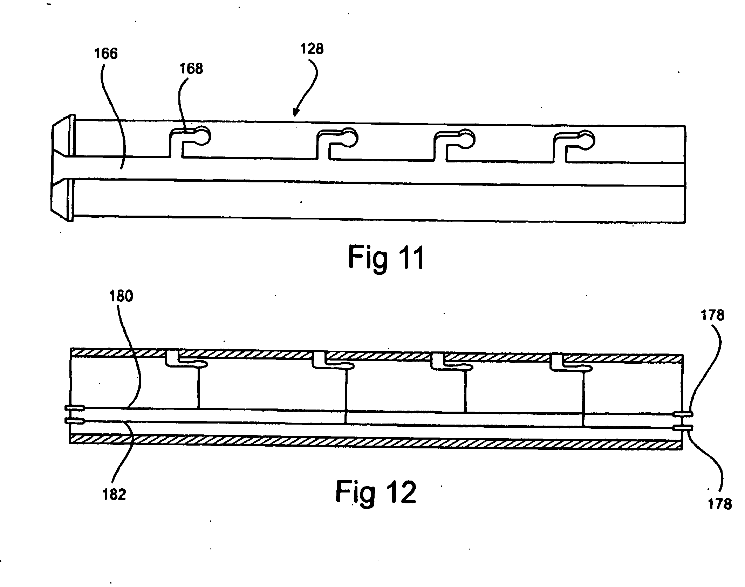

Referring to Figures 3-13 of the accompanying drawings, an embodiment of a photovoltaic tile assembly (hereinafter referred to as simply "assembly") 100 comprises a base tile 112 having at least one (and in this particular embodiment, four) solid region 114 through which a mechanical fastener such as a nail or screw is driven for fastening the base tile 112 to an underlying structure such as a roof structure. It is envisaged that the solid region will not necessarily be predrilled or formed with holes for the mechanical fasteners to allow an installer to select the best location for the fasteners. However in a variation of this embodiment one or more such holes can be formed.

The assembly 100 further comprises one or more cover tiles 116 each having a photovoltaic cell 118 for converting solar energy into electricity. The cell 118 generates an electric current that is made available at positive and negative output terminals 120a and 120b respectively, (hereinafter referred to in general as "output terminals 120").

Two forms of cover tile 116 may be provided. In a first form of cover tile 116 the cell 118 is provided on substantially the whole surface area of the tile 116 except the portion of surface area having the output terminals 120. In a second form of cover tile 116 about one third of the surface area immediately below the output terminals 120 is left blank (ie without a photovoltaic cell 118)so that only about the lower two thirds of the surface area of the tile 116 is formed with the cell 118. As explained in greater detail below in the tile assembly 100, the cover tiles 116 overlap by one third of their surface area with the first form of cover tile 116 being uppermost and fully exposed while the underlying tile 116 is of the second form and has the upper third of its surface area covered.

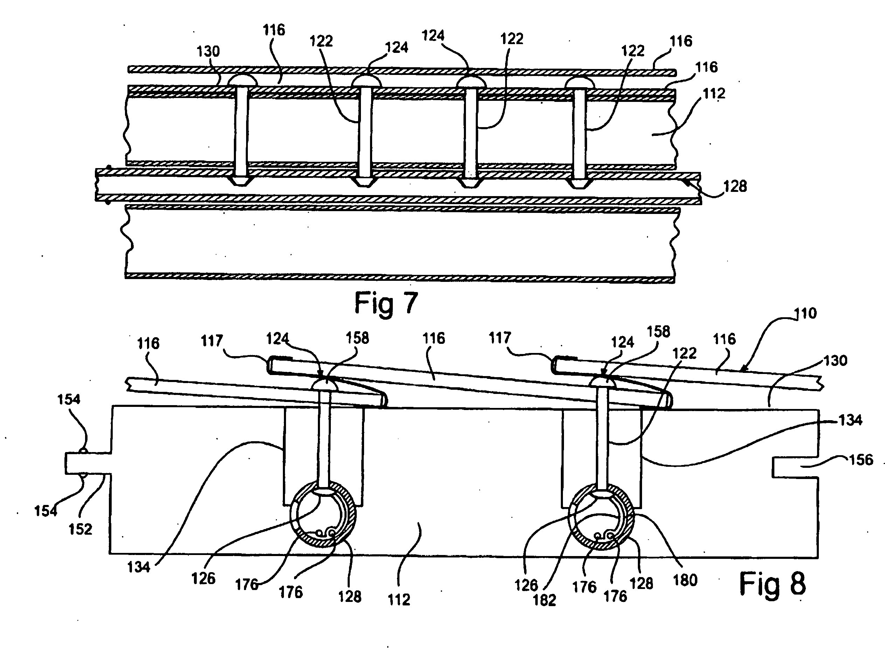

The cover tiles 116 are electrically and mechanically coupled to a corresponding base tile 112 by electrical connection posts (hereinafter referred to in general as "posts") 122. The posts 122 are supported within the base tile 112 and have a first end 124 that contacts with and provides electrical connection with respective output terminals 120 of a cover tile 116. In addition the first end 124 penetrates through the cover tile 116 to provide mechanical attachment of the cover tile to the base tile 112. As explained in greater detail below particularly with reference to Figure 8, each post 122 also has a second end 126 that is electrically coupled to an electrical connection tube 128 that facilitates the electrical coupling of the cover tile 116 to the energy management system 20.

Looking at the components of the assembly 100 in more detail, the base tile 112 is in the configuration of a square plate having a planar and substantially continuous upper surface 130. The continuity of the upper surface 130 is interrupted only by the extension of the posts 122 through the surface 130 in a direction perpendicular to the plane of the surface 130. The posts 122 are in this embodiment arranged in two parallel lines. As explained further below, a waterproof seal is formed about the posts 122 where they extend through the surface 130.

An under side 132 of the base tile 112 is formed with a plurality of walls or ribs dividing the underside 132 into a number of different sections. In this particular embodiment, each of the four corners of the base tile 112 is formed of solid material creating the solid portions 114 through which a mechanical fastener such as a nail or screw can be driven. A pair of parallel walls 134 extends between opposite sides 136 and 138 of the base 112 and in part form a boundary of the solid portions 114. The base further comprises a plurality of further walls 140 extending perpendicular to the walls 134 and which also bound respective sides of the solid portions 114. The walls 140 extend between respective adjacent sides 142 and 144 of the base tile 112 and the nearest wall 134. By this configuration, the under side 132 of the base 112 is formed with compartments 146 adjacent the sides 142 and 144 and a larger central compartment 148.

The compartments 146 and 148 may be left as unfilled voids. However it is envisaged that the compartments 146 will contain a thermal insulation material and the compartment 148 may optionally contain an electrical power storage means such as a battery 150 with any remaining space in the void 148 filled with insulating material. Of course in the event that battery 150 is not included the entire compartment can be filled with thermal insulation material. In either case the base tile 112 containing the thermal insulation material, or otherwise made from a thermal insulating material is able to perform an insulation function. The walls 134 and 140 may also be provided with longitudinal extending recesses for seating the connection tubes 128. Each tube is of a length equal to the length of the recess in the walls 134, 140 in which they are seated.

The assembly 100 also comprises a tile coupling system for providing a water proof coupling between adjacent tile assemblies. In this embodiment the coupling system comprises a laterally extending tongue 152 that runs along adjacent sides 138 and 144 of the base tile 112. Each tongue 152 is further provided with a longitudinally extending rubber seal 154. The tile coupling system also comprises complementary grooves 156 extending longitudinally along adjacent sides 136 and 142 of a base tile 112. The provision of the tongues 152 and grooves 156 enables a tile assembly 100 to be connected in a waterproof manner on all four sides to other identical tile assemblies 100.

With particular reference to figures 7,8 and 9, it can be seen that each post 122 is the form of a tube having an opening at the first end 124 for receiving an end cap in the form of a rubber grommet 158. The end cap or grommet 158 is formed of a resilient material such as rubber and retained in the end 124 by one or both of an interference fit and the use of adhesives. The post 122 is itself made of an electrically conductive material such as steel or stainless steel and is formed with a pair of circumferential and axially spaced apart grooves or recesses 160. A conductive spring 162 is electrically and mechanically coupled to the end 126.

The recesses 160 receive corresponding protrusions formed in the holes formed in the base tile 112 into which the posts 122 are inserted. This is arranged to provide a water proof seal between each post 122 and the base tile 112. More particularly, the posts 122 are pushed into corresponding holes in the base tile 112 so that the end 124 protrudes from the surface 130 to thereby facilitate connection with the cover tile 116, while the end 126 protrudes into the recess formed in the walls 134 to enable coupling with respective connection tubes 128.

Figures 8, 10, 11 and 12 depict in more detail the nature of the electrical connection tubes 128. The tube comprises an opening 164 to engage and provide electrical connection with the second ends 126 of respective posts 122. Each opening 164 comprises a longitudinal slot 166 which, in this embodiment extends for the entire length of the tube 128, together with a plurality of secondary slots 168 that extend from the longitudinal slot 166. The secondary slots 168 comprise a first length 170 that extends in a circumferential direction, and a second length 172 that extends in the axial direction. The second length 172 terminates in a circular portion 174.

Electrical end connectors 176 and 178 are provided at each axial end of a connection tube 128 to enable end to end electrical connection between adjacent tubes 128. In this regard, the end connectors 176 may be in the form of spring loaded or biased male plugs while the end connectors 178 may be in the form of female sockets. The male plugs 176 can be retracted to be substantially flush with the adjacent end of its corresponding tube 128 during installation of the PV tiles, and subsequently be pushed by spring action into corresponding female sockets 178. A first conductor 180 connects one of the end connectors 176 to one of the end connectors 178 and also provides electrical coupling with a group of the secondary slots 168. Similarly, a second conductor 182 provides electrical connection between the other end connectors 176 to 178 and to a second group of the secondary slots 168. More particularly, the conductors 180 and 182 provide electrical connection to alternate slots 168 which are electrically connected with positive and negative terminals 120a and 120b of the PV cells 118. Thus in effect, the positive terminals 120a of each of the PV cells 118 are electrically coupled with the conductor 180 while the negative terminals 120b of each of the PV cells 118 is electrically connected with the conductor 182.

Each of the axial ends of the tube 128 can be formed in a manner to facilitate mechanical coupling with an adjacent tube. Ideally this will be by way of an interference fit, or "click connection" between adjacent tubes 128.

It is envisaged that the base tiles 112 will be provided in a pack together with a pack of grommets 158, with the cover tiles 116 provided in separate packs.

To install the tile assemblies 100 on the roof frame structure 14, the posts 122 (without the grommets 158) are inserted into corresponding holes formed in the base tiles 112 so that the ends 124 protrude beyond the surface 130 and the ends 126 protrude into the recesses or grooves formed in the walls 134 and 140. Next an individual base tile 112 is attached to a roof structure by hammering nails through the solid portions 114. Respective connection tubes 128 are then placed in the recesses in the walls 134 and 140 with the ends 126 of the posts 122 located in the slots 166 and aligned with the secondary slots 168. The tubes are then rotated and slid to lock them in place with the ends 126 of the posts 122 engaged in respective circular portions 174 and the springs 162 pressing on an under surface of the circular portion 174 to facilitate electrical contact with a corresponding conductor 180 or 182.

This process is then repeated for the next adjacent base tile 112, which, after the posts 122 have been inserted is pushed up against the previously laid base tile 112 so that the tongue 152 of one of the base tiles is received in the groove 156 of the other base tile 112. During the installation of the connection tube 128 in the adjacent tile the male plugs 176 of one tube may be retracted while the connection tube 128 of the adjacent base tile 112 is rotated into place. Thereafter the plugs 176 will mate with and extend into the female socket 178 assuming correct alignment of the tubes 128 of the previously laid and adjacent tiles.

In perhaps a simpler installation process, the base tiles 112 may be assembled to include the posts 122 and the connection tubes 128 prior to being fixed to the roof frame structure 14. In this process when the next tile 112 is laid an installer need only engage the tongues 152 and groove 156, and the male plugs 176 with the female sockets 178 prior to fixing the next tile 112 to the roof frame structure 14.

Once the base tiles 112 have been laid and secured in place the cover tiles 116 are simply clipped onto the corresponding base tiles 112 by pushing the ends 124 through corresponding holes formed in the cover tile 116 and then pushing the grommets 158 into the ends 124 of the posts 122. These holes correspond with the output terminals 120 of the cover tiles 116. As opposite ends of each of the connecting tubes 128 are in electrical contact with each other by virtue of coupling of the connectors 176 of one tube with the connectors 178 of an adjacent tube, electrical connection is provided continuously along each row of tile assemblies 100. Electrical connection can then be provided with an adjacent row by use of similar tube connectors 128 seated in recesses formed in the walls 170 (see Figure 3). Electric current from the assemblies 100 is coupled the power management system 20 via cables 22.

The cover tiles 116 are dimensioned and configured to vertically overlap each other by about one third of their surface area as in a traditional shingle or tile roof so that a lower portion of one tile overlaps an upper portion of a vertically adjacent but lower tile. Further, a lower portion of a lowest cover tile 116 on a particular base tile 112 will overlap an upper portion of an uppermost over tile 116 on a vertical adjacent but lower base tile 112. Additionally the cover tiles 116 will be made from water proof materials. Accordingly the cover tiles 116, laid in this manner, will in effect provide a second water proof layer for the roof 13 and additional thermal insulation.

As depicted in Figures 7 & 8 the lower portion of each tile rests on and is cushioned by the line of grommets 158 of the underlying cover tiles 116. In addition when attaching the cover tiles 116, conventional tile clips or hooks 117 may be inserted between adjacent cover tile 116 which hook over a bottom edge of an overlying tile 116 and hook under the upper edge of an adjacent underlying tile.

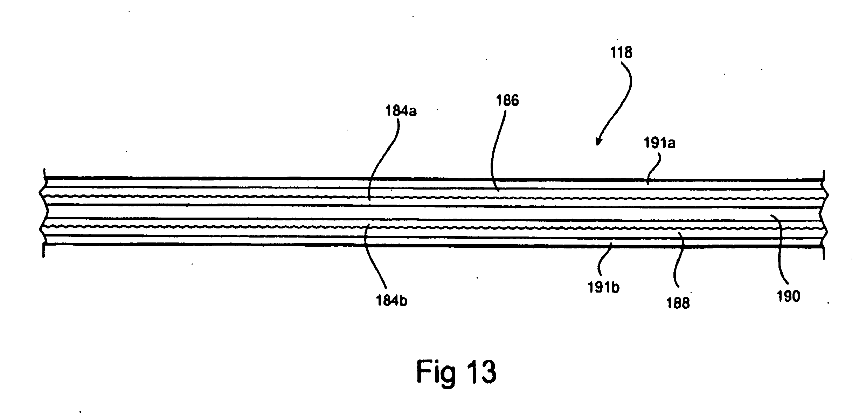

The PV cells 118 may be of conventional construction. However to enhance efficiency, a PV cell 118 as depicted in Figure 13 may be used which comprises a plurality of layers of photovoltaic material 184a, 184b that absorb different frequencies of light where a one way mirror film 186 is provided on a side of the cell 118 incident to incoming light and located above the layer 184a, with a reflector 188 provided in a layer below the layer 184b and facing the one way mirror film 186. In this way, light passing into the cell 118 through the one way mirror 186 is continually reflected through the photovoltaic layers 184a and 184b between the one way mirror 186 and the reflecting surface 188. An optically transparent separating layer 190 may be provided between the photovoltaic layers 184a and 184b. Additionally protective films or layers 191a and 191b are provided on opposite sides of the cell 118 adjacent the mirror film 186 and the reflector 188 respectively.

### Hydroelectric System 200

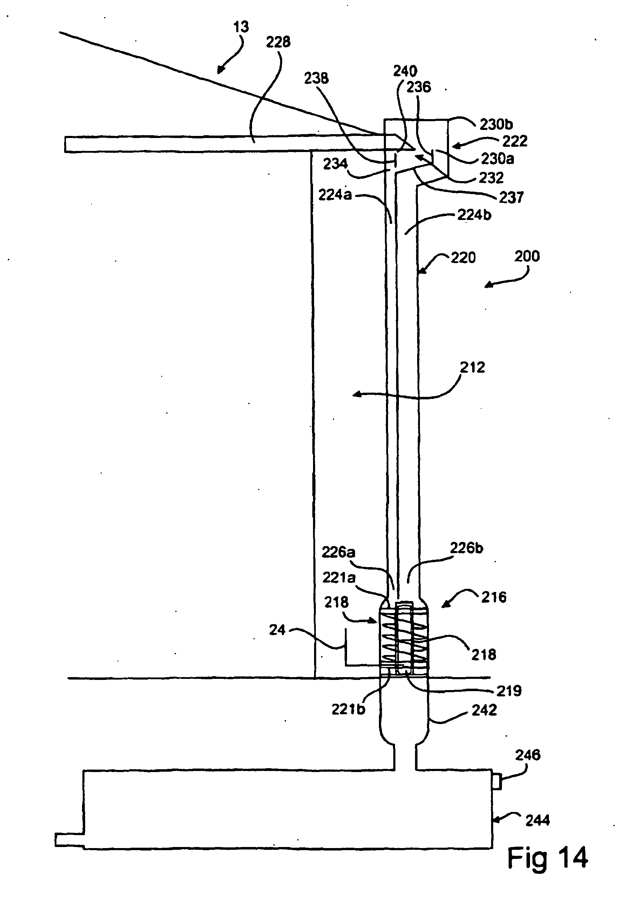

Figures 14 - 16 of the accompanying drawings illustrate an embodiment of a hydroelectric system 200 for converting kinetic energy from water flowing off the roof 13 of the house 12 into electrical energy. The system 200 comprises a turbine 216 having a rotor 218 and a generator 219 which is driven by the rotor 218, and at least one down pipe 220 having an upper end 222 for receiving the water run off from the roof 13. The down pipe 220 comprises channels 224a and 224b (hereinafter referred to in general as "channels 224") that extend from the upper end 222 to respective outlets 226a and 226b (hereinafter referred to in general as "outlets 226"). Each of the outlets 226 is disposed to direct water flowing therefrom onto the rotor 218 to cause rotation of the rotor 218 in the same direction. As explained in greater detail later in this specification the channels 224 are further configured in a manner so that the channel 224a overflows into the channel 224b.

Upper and lower fixing rings 221a and 221b hold the turbine 216 in place within the downpipe 220 as the rotor 218 rotates, and may be used to route the cables 24 between the generator 219 and the energy management system 20.

The system 200 further comprises a gutter 228 that receives the water from the roof 13 and directs that water into the down pipe 220. The channels 224a and 224b are configured in a manner so that water entering the down pipe 220 initially flows through the channel 224a and out from the outlet 226a onto the rotor 218 to drive the generator 219. However in a heavy downpour the channel 224a may overflow into the channel 224b. The overflow water then flows through the channel 224b through the outlet 226b to turn the rotor 218 thereby providing further drive to the generator 219.

The overflow of water from channel 224a to 224b is facilitated by forming the channels 224 with respective upper edges of progressively increasing height whereby water overflowing the upper edge of one channel, for example channel 224a, can subsequently flow into the adjacent channel 224b. In this regard, it can be seen from Figure 14 that the channel 224a has an upper edge 230a while the channel 224b has an upper edge 230b which is higher than the upper edge 230a. Thus, if the channel 224a fills with water and overflows, the overflow flows over the upper edge 230a into the channel 224b. It will be appreciated that if for example the down pipe 220 where provided with a further third channel, water would flow into the third channel after water has over flowed both the upper edge 230a of the first channel 224a and the upper edge 230b of the second channel 224b.

In order to provide a controlled steady flow of water through the channel 224a, the upper end 222 of the down pipe 220 is provided with a water flow regulating reservoir 232. The reservoir 232 comprises an upright wall 236 that incorporates the upper edge 230a of the channel 224a, a base 237 that slopes downwardly, and a second upright wall 238 spaced from the wall 236.

The reservoir 232 is provided with two outlets to the channel 224a. A first outlet 234 comprises a slot or series of holes formed in the wall 238 near its junction with the base 237. The second outlet, which is spaced above the first outlet, is a horizontal slot 240 formed near an upper end of the wall 238. The slot 240 in effect constitutes a spill way to the channel 224a. Thus when water collects in the reservoir at a level below the slot 240 it flows into the channel 224a via the first outlet 234. The outlet 234 is dimensioned to provided a steady continuous stream of water down the channel 224a when a head of water is contained within the reservoir 232. If rainwater volume increases sufficiently water will initially flow through the slot 240 and flow into the channel 224a providing additional pressure to drive the turbine 216. Should the water level in the reservoir 232 increase at a sufficiently greater rate than it flows out from the outlet 234 and through the slot 240 it may then overflow the edge 230a to flow down the second channel 224b.

The channels 224 may be provided with either the same or different hydraulic diameter. However, in a preferred embodiment the channel 224a may have a smaller hydraulic diameter than the channel 224b. The selection of the hydraulic diameter for the channel 224a, the size of the opening 234, and the volume of the reservoir 232 may be selected to provide a constant flow of water through the channel 224a.

Water flowing through the down pipe 220 and through the rotor 218 can flow via a tail portion 242 of the down pipe 220 into a water tank 244. The water tank 244 may be disposed either on the ground or underground. The tank 244 stores rainwater which can be used for various purposes including non potable uses such as watering of a garden, cleaning outdoor areas, washing machines and dishwashers, or alternately with the provision of appropriate filters, used for drinking water. Additionally, the water in the tank 244 may be pumped through a solar heating system to provide either heated water for use within the building 12 such as for showers and washing machines, or alternately pumped through radiators for heating purposes. In such embodiments, pumping of the water from the tank 244 may ideally be powered by electricity generated by solar cells on the roof 13. The tank 244 may also be provided with an overflow valve 246 that is configured to open to allow excess water to drain from the tank 244 if the water pressure on the tank 244 is above a predetermined level that would be exceeded prior to the entirety of the down pipe 220 being filled with water.

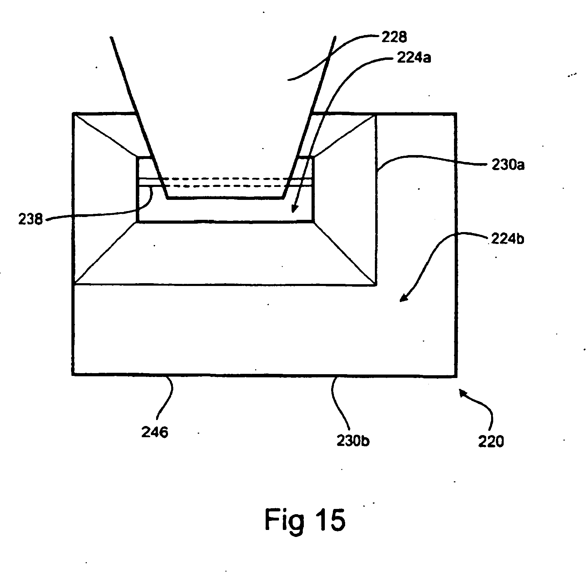

Figure 15 illustrates a particular configuration of a down pipe 220 where the channel 224a comprises in effect a pipe within the down pipe. The gutter 228 feeds water directly to the mouth or opening of the channel 224a which, when completely filled with water, can overflow into the channel 224b which constitutes the region of the down pipe 220 between the outside of the channel 224a and the inside of an outer pipe 246 defining the down pipe 220.

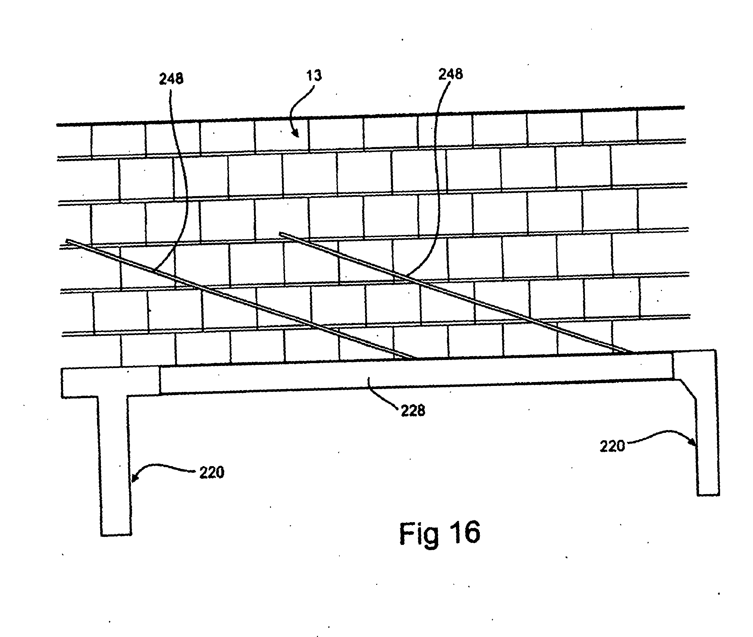

Referring to Figure 16, it can further be seen that the hydroelectric system 200 may also comprise one or more roof channels 248 that extend diagonally from an upper portion of the roof 13 to the gutter 228. The roof channels 248 act to direct rain running of the roof 13 to flow in a direction at an acute angle to the direction of flow of water in the gutter 228. This provides added momentum or velocity to the water in the gutter 228 to thereby increase its kinetic energy. Depending on the state of the reservoir 232 and the size of the opening 234, the increase in kinetic energy provided to the water may provide greater electrical energy output from the turbine.

Electricity generated by each turbine 216 is fed via corresponding cable 24 to the power management system 20.

Now that an embodiment of the hydroelectric system 200 has been described in detail it will be apparent to those skilled in the relevant arts that numerous modifications and variations may be made without departing from the basic inventive concepts. For example, system 200 depicts a down pipe being divided into two channels 224a and 224b. However as previously mentioned, the down pipe 220 can be divided into more than two channels. Further, while it is believed that a rotor 218 in the form of an Archimedes screws may constitute a most efficient form of rotor, however the wheels or propellers may be used. Also the second outlet of the reservoir 232 which is described above, and shown, as a slot 240 can take alternate forms. For example the wall 238 can be simply made of a height equal to the bottom of the slot 240, so that the upper most edge of the wall 238 acts as a dam wall over which water flows. In a further variation the slot 240 can be replaced with a plurality of holes at the same height in the wall 238.

### Wind Energy Conversion System 300

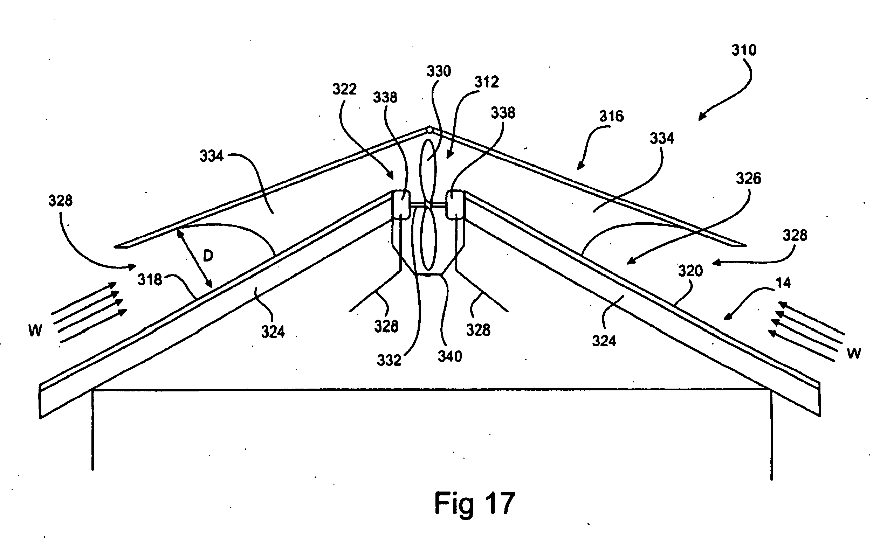

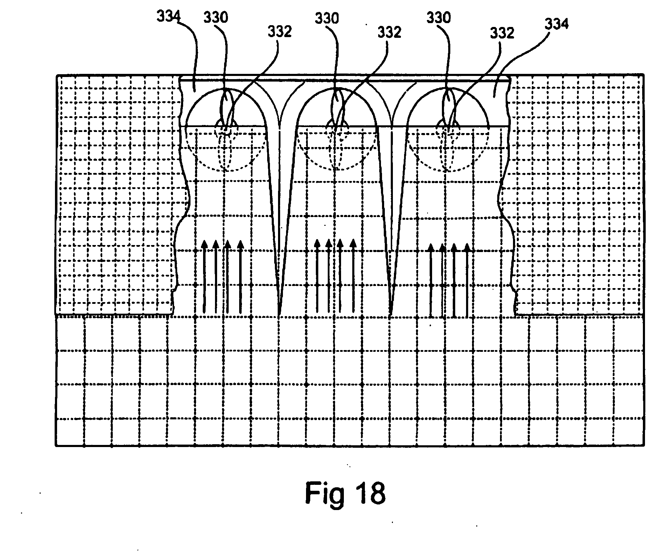

Figures 17 and 18 of the accompanying drawings, illustrate an embodiment of the wind energy conversion system 300 for the building 12 as comprising one or more wind powered turbines 312, together with the pitched roof structure 14 on which the turbines 312 are mounted, the roof structure having a first pitch and, a cover 316 supported on the pitched roof structure 14 above the turbines 312. The cover 316 has a second pitch that is less than the first pitch, i.e. less than the pitch of the pitched roof structure 14.

The pitched roof structure 14 has two sloping sides 318 and 320 that converge toward each other in an upward direction. The turbines 312 are supported on the structure 14 in a ridge region 322 created by and between the converging sides 318 and 320. Other than leaving the crest or ridge region 322 of the structure 14 open for the mounting of the turbines 312, the roof structure 14 is of generally conventional form and configuration and thus will comprise a plurality of roof beams 324 together with rafters, joists and battens (not shown).

The cover 316 overlies an upper portion 326 of the roof structure 14 and extends to opposite sides of the ridge region 322. In effect, the cover 316 and the upper portion 326 of the roof structure 14 create or act as a wind tunnel 328 that directs wind W flowing upwardly on the sides 318 and 320 through the turbines 312.

As previously mentioned, the pitch of the cover 316 is less' than the pitch of the roof structure 14 so that the perpendicular distance D between the cover 316 and the upper portion 326 of the first structure 14 decreases in a direction toward the ridge region 322. Thus, the wind tunnel 328 reduces in cross section area toward the ridge region 322. This has the effect of increasing air pressure and thus air speed through the turbines 312. It will be appreciated that the configuration of the wind tunnel 328 has the effect of directing wind from opposite sides of the structure 14 to flow through the turbines 312.

Each turbine 312 comprises a wind rotor 330 coupled to a drive shaft 332 passing through an axis of rotation of the wind rotor 330. The drive shaft 332, and thus the axis of rotation of the propeller 330 is perpendicular or transverse to a line or direction of extent of the ridge region 322. Thus, the drive shaft 332 is substantially parallel to the direction of air flow through the turbine 312.

To further assist in concentrating the air flow through the turbine 312 the system 300 further comprises a respective cowling 334 for each of the turbines 312. Each cowling 334 surrounds an upper portion of a corresponding turbine 312 extending above the beams 324 and has open opposite ends directing air flowing up the roof structure 14 through the turbine 312. The cowlings 334 are ideally aerodynamically shaped and configured to concentrate air flow across or through the wind rotor 330. In this regard, for example, an inside surface of the cowling 334 may be configured to progressively taper from the opposite openings to a central region in which the wind rotor 330 rotates. As seen in Figures 17 and 18 each cowling extends in the vertical direction between an inner surface of the cover 316 and an outer surface of the roof structure 14.

Opposite ends of the drive shaft 332 are coupled to respective generators 338 for generating electricity. The generators 338 can be configured or driven to produce electric current of the same phase which in turn is provided to the power management system 20 via cables 26.

It will be appreciated that wind passing through the turbines 312 in opposite directions cause the wind rotors 330 to rotate in opposite directions. Depending on the type of generators 338 incorporated in the system 300, it may be important to maintain the phase of the electric current produced by the generators 338 irrespective of the direction of rotation of the propeller 330. This can be achieved by the provision of gear boxes between the shaft 332 and the generators 338 so that irrespective of the direction of rotation of the propeller 330 and drive shaft 332, the direction of rotation of the rotors (not shown) of the generators 338 remains the same.

A gutter 340 is provided that runs along the ridge region 322 beneath the turbines 312 for catching any water that may be blown through the tunnel 328. The gutter 340 may be plumbed into the gutters 228 of the hydroelectric system 200.

From the above description it will be appreciated that embodiments of the energy conversion system 10 utilize one or more renewable energy sources of solar radiation, wind, and rain capable of generating power from the rooves of buildings of different size, shape and architecture. The system 10 allows a "mix and match" approach to power generation where designers/builders can select the most efficient specific energy conversion systems/power generation systems for the prevailing conditions of the location of the building at hand.

In the claims of this application and in the description of the invention, except where the context requires otherwise due to express language or necessary implication, the words "comprise" or variations such as "comprises" or "comprising" are used in an inclusive sense, i.e. to specify the presence of the stated features but not to preclude the presence or addition of further features in various embodiments of the invention.

## Claims

1. A roof based energy conversion system (10) comprising:
a roof frame structure (14); and,
a plurality of solar energy converting tiles (100), each of the solar energy converting tiles (100) comprising a base tile (112) that is fixed to at least a portion of the roof frame structure (14) and one or more photovoltaic cover tiles (116) attached to a corresponding base tile (112), wherein the base tiles (112) are configured to sealingly engage each other along adjacent edges to form a substantially waterproof cladding for the portion of the roof structure (14), each base tile has a planar substantially continuous surface (130) on which the cover tiles (116) lie, **characterized by** a plurality of posts (122) that extend through the surface (130) and couple the cover tiles (116) to the base tile (112).

2. The energy conversion system (10) according to claim 1, **characterised by** an electrical connection tube (128) coupled to an underside (132) of the base tile (112) wherein the posts (122) electrically and mechanically couple at one end (126) with the electrical connection tube (128).

3. The energy conversion system (10) according to claim 1 or 2 , wherein the plurality of solar energy converting tiles (100) further comprises one or more thermal cover tiles attached to a corresponding base tile (112) that convert solar energy to thermal energy.

4. The energy conversion system (10) according to claim 3, wherein the roof frame structure (14) comprises at least two sloping sides that converge toward each other in an upward direction.

5. The energy conversion system (10) according to claim 4, wherein the plurality of solar energy converting tiles (100) comprises at least one photovoltaic cover tile (116) and at least one thermal tile, the tiles being arranged so that the at least one photovoltaic cover tiles (116) is fixed at higher locations on the portion of the roof structure (14) than the at least one thermal cover tile.

6. The energy conversion system (10) according to claims 3, wherein the cover tiles for both the photovoltaic cover tiles and the thermal cover tiles are formed so as to have respective exposed surfaces that are of substantially identical appearance.

7. The energy conversion system (10) according to any one of claims 1 - 6 wherein a plurality of photovoltaic cover tiles (116) are attached to each base tile (112) and wherein at least two of the photovoltaic cover tiles (116) overlap each other.

8. The energy conversion system (10) according to any one of claims 1 - 7 wherein the base tiles (112) are formed to provide thermal insulation to the roof frame structure.

9. The energy conversion system (10) according to any one of claims 1-8 further comprising a hydro-electric system (200) configured to convert kinetic energy from water flowing off the portion of the roof to electrical energy.

10. The energy conversion system (10) according to claim 9, wherein the hydro-electric system (200) comprises one or more gutters (220) and downpipes (228); and, one or more water turbines (216) wherein the gutters (220) and downpipes (228) are arranged to collect rain flowing off the portion of the roof frame structure (14) to produce a water flow that drives the or each water turbine (216).

11. The energy conversion system (10) according to any one of claims 1-10 further comprising a wind energy conversion system (300) having one or more wind turbines (312) supported by the roof frame structure (14) which convert kinetic energy of a moving air mass to electrical energy.

12. The energy conversion system (10) according to claim 11, wherein the wind energy conversion system (300) further comprises a cover (316) that overlies the one or more wind turbines (312)/to create, together with the roof frame structure (14), a wind tunnel (328) that directs moving air to flow up the roof frame structure (14) through the one or more wind turbines (312).

13. The energy conversion system (10) according to any one of claims 1-8 in combination with claim 9 or 10 and claim 11 or 12, further comprising an energy management system (20) which receives and manages the electrical energy from the plurality of solar energy converting tiles (100), hydro-electric system (200) and the wind energy conversion system (300).

14. The energy conversion system (10) according to claim 13, wherein the energy management system (20) comprises a connection (30,32) to an electricity supply grid and is configured to manage two way flow of electrical energy between the energy conversion system and the supply grid.

15. The energy conversion system according to claim 13 or 14, wherein the energy management system (20) comprises an electrical energy storage apparatus, the energy management system (20) being configured to provide electrical energy to the supply grid when the electricity storage apparatus is in the fully charged state, and connects the supply grid to the electricity storage apparatus when the electricity storage apparatus has a charge level below a threshold level.

## Patentansprüche

1. Dach-Energieumwandlungssystem (10) mit
einer Dach-Rahmenstruktur (14) und
einer Mehrzahl von Solarenergie umwandelnden Dachziegeln (100), wobei jeder der Solarenergie umwandelnden Dachziegeln einen Grund-Dachziegel (112) umfasst, der an mindestens einem Abschnitt der Dachrahmen-Struktur (14) befestigt ist und einen oder mehrer photovoltaische Abdeckungs-Dachziegeln (116) umfasst, die an einem entsprechenden Grund- Dachziegel (112) angebracht werden, wobei die Basis-Dachziegeln (112) konfiguriert sind, um entlang angrenzender Ränder dichtend ineinander zu greifen, um eine im Wesentlichen wasserdichte Eindeckung für den Abschnitt der Dachstruktur (14) zu bilden und jeder Grund-Dachziegel eine ebene im wesentlichen durchgängige Oberfläche (130) hat auf welcher die Abdeckungs-Dachziegeln liegen,
**gekennzeichnet durch,**
eine Mehrzahl von Stiften (122), welche **durch** die Oberfläche (130) ragen und die Abdeckungs-Dachziegeln (116) mit den Grund-Dachziegeln (112) verbinden.

2. Energieumwandlungssystem (10) nach Anspruch 1, **gekennzeichnet durch** ein elektrisches Verbindungsrohr (128), welches an einer Unterseite (132) des Grund-Dachziegels (112) befestigt ist, wobei die Stifte (122) an einem Enge (126) elektrisch und mechanisch mit dem elektrischen Verbindungsrohr (128) in Verbindung stehen.

3. Energieumwandlungssystem (10) nach Anspruch 1 oder 2, **dadurch gekennzeichnet, dass** die Mehrzahl der Solarenergie umwandelnden Dachziegel (100) eine oder mehr thermische Abdeckungs-Dachziegel umfasst, welche an einem korrespondierenden Grund-Dachziegel (112) befestigt sind und Solarenergie in thermische Energie umwandeln.

4. Energieumwandlungssystem (10) nach Anspruch 3, **dadurch gekennzeichnet, dass** die Dach-Rahmenstruktur (14) mindestens zwei geneigte Seiten umfasst, die in Richtung zu einander in einer Aufwärtsrichtung zusammenlaufen.

5. Energieumwandlungssystem (10) nach Anspruch 4, **dadurch gekennzeichnet, dass** die Mehrzahl der Solarenergie umwandelnden Dachziegel mindestens einen photovoltaischen Abdeckungs-Dachziegel (116) und mindestens einen thermischen Dachziegel umfasst, wobei die Dachziegel derart angeordnet sind, dass zumindest ein photovoltaischer Abdeckungs-Dachziegel (116) an höheren Stellen auf dem Abschnitt der Dachstruktur (14) befestigt ist als der zumindest eine thermische Abdeckungs-Dachziegel.

6. Energieumwandlungssystem nach Anspruch 3, **dadurch gekennzeichnet, dass** die Abdeckungs-Dachziegel sowohl für die photovoltaischen Abdeckungs-Dachziegel als auch für die thermischen Abdeckungs-Dachziegel derart ausgebildet sind, sodass diese jeweils eine ausgestellte Oberflächen haben, die von im Wesentlichen identischen Aussehen sind.

7. Energieumwandlungssystem (10) nach einem der Ansprüche 1 - 6, **dadurch gekennzeichnet, dass** eine Mehrzahl der Abdeckungs-Dachziegel (116) an jedem Basis-Dachziegel (112) befestigt sind und mindestens zwei der photovoltaischen Abdeckungs-Dachziegel (116) einander überlappen.

8. Energieumwandlungssystem (10) nach einem der Ansprüche 1 - 7, **dadurch gekennzeichnet, dass** die Basis-Dachziegel (112) ausgebildet sind, um der Dachrahmen-Struktur Wärmeisolierung zur Verfügung zu stellen.

9. Energieumwandlungssystem (10) nach einem der Ansprüche 1-8 weiter **gekennzeichnet, durch** ein hydroelektrisches System (200), welches konfiguriert ist, um kinetische Energie von Wasser, welches vom Abschnitt des Dachs abfliesst, in elektrische Energie umzuwandeln.

10. Energieumwandlungssystem (10) nach Anspruch 9, **dadurch gekennzeichnet, dass** das hydroelektrische System (200) eine oder mehrere Abflussrinnen (220), Ablaufrohre (228) und eine oder mehrere Wasserturbinen (216) umfasst, wobei die Abflussrinnen (220) und Ablaufrohre (228) angeordnet sind, um Regen, welcher vom Abschnitt der Dachrahmen-Struktur (14) abfliesst zu sammeln, um einen Wasserstrom zu erzeugen, welcher die oder jede Wasserturbine (216) antreibt.

11. Energieumwandlungssystem (10) nach einem der Ansprüche 1-10 weiter **gekennzeichnet durch** ein Wind- Energieumwandlungssystem (300), das eine oder mehrere Wind-Turbinen (312) besitzt, welche **durch** die Dach-Rahmenstruktur (14) unterstützt sind und kinetische Energie einer bewegten Luftmasse in elektrische Energie umwandeln.

12. Das Energieumwandlungssystem (10) nach Anspruch 11, **dadurch gekennzeichnet, dass** das Wind-Energieumwandlungssystem (300) eine Abdeckung (316) umfasst, die eine oder mehrere Wind-Turbinen (312) überlagert, um, zusammen mit der Dachrahmen-Struktur (14), einen Windtunnel (328) zu erzeugen, der bewegte Luft die Dachrahmen-Struktur (14) hinauf leitet, damit die Luft durch die eine oder mehrere Wind-Turbinen (312) strömen.

13. Energieumwandlungssystem (10) nach einem der Ansprüche 1-8 in Kombination mit Anspruch 9 oder 10 und Anspruch 11 oder 12, weiter **gekennzeichnet durch** ein Energie-Verwaltungssystem (20), das die elektrische Energie von der Mehrzahl der Solarenergie umwandelnden Dachziegeln (100), vom hydroelektrischen System (200) und vom Wind-Energieumwandlungssystem (300) empfängt und verwaltet.

14. Energieumwandlungssystem (10) nach Anspruch 13, **dadurch gekennzeichnet, dass** das Energie-Verwaltungssystem (20) einen Anschluss (30,32) zu einem elektrischen Versorgungsnetz umfasst und konfiguriert ist, um einen Zweiwegfluss der elektrischen Energie zwischen dem Energieumwandlungssystem und dem Versorgungsnetz zu verwalten.

15. Energieumwandlungssystem (10) nach Anspruch 13 oder 14, **dadurch gekennzeichnet, dass** das Energie-Verwaltungssystem (20) eine elektrische Speichervorrichtung umfasst, und konfiguriert ist, um elektrische Energie dem Versorgungsnetz zu Verfügung zu stellen, wein die elektrische Speichervorrichtung sich im voll aufgeladenen Zustand befindet und das Versorgungsnetz mit der elektrischen Speichervorrichtung verbindet, wenn die elektrische Speichervorrichtung einen Ladezustand unterhalb eines Schwellenwerts besitzt.

## Revendications

1. Système de conversion d'énergie (10) basé sur un toit comprenant:
une structure de cadre de toit (14) et
une pluralité de tuiles de conversion d'énergie solaire (100), chacune des tuiles de conversion d'énergie solaire (100) comprenant une tuile de base (112) qui est fixée à au moins une portion de la structure du cadre de toit (14) et une ou plusieurs tuiles de couverture photovoltaïques (116) fixées à une tuile de base correspondante (112), dans lequel les tuiles de base (112) sont configurées pour s'emboîter de manière hermétique l'une avec l'autre le long d'arêtes adjacentes pour former un bardage substantiellement imperméable à l'eau pour la portion de la structure de toit (14), chaque tuile de base a une surface plane substantiellement continue (130) sur laquelle les tuiles de couverture (116) reposent, **caractérisé par** une pluralité de montants (122) qui s'étendent à travers la surface (130) et qui relient les tuiles de couverture (116) à la tuile de base (112).

2. Système de conversion d'énergie (10) selon la revendication 1, **caractérisé par** un tube de connexion électrique (128) relié à un côté inférieur (132) de la tuile de base (112) dans lequel les montants (122) sont reliés électriquement et mécaniquement à une extrémité (126) au tube de connexion électrique (128).

3. Système de conversion d'énergie (10) selon la revendication 1 ou 2 dans lequel la pluralité de tuiles de conversion d'énergie solaire (100) comprend de plus une ou plusieurs tuiles de couverture thermiques (100) fixées à une tuile de base correspondante (112) qui convertissent l'énergie solaire en énergie thermique.

4. Système de conversion d'énergie (10) selon la revendication 3 dans lequel la structure de cadre de toit (14) comprend au moins deux côtés en pente qui convergent l'un vers l'autre dans une direction vers le haut.

5. Système de conversion d'énergie (10) selon la revendication 4 dans lequel la pluralité de tuiles de conversion d'énergie solaire (100) comprend au moins une tuile de couverture photovoltaïque (116) et au moins une tuile thermique, les tuiles étant arrangées de telle manière que la tuile de couverture photovoltaïque qui existe au moins (116) est fixée à des endroits sur la portion de la structure de toit (14) qui sont plus élevés que la tuile de couverture thermique qui existe au moins.

6. Système de conversion d'énergie (10) selon la revendication 3 dans lequel les tuiles de couverture pour à la fois les tuiles de couverture photovoltaïques et les tuiles de couverture thermiques sont formées de manière à avoir des surfaces exposées respectives qui sont d'apparence substantiellement identique.

7. Système de conversion d'énergie (10) selon l'une quelconque des revendications 1 à 6 dans lequel une pluralité de tuiles de couverture photovoltaïques (116) est fixée à chaque tuile de base (112) et dans lequel au moins deux des tuiles de couverture photovoltaïques (116) se chevauchent l'une l'autre.

8. Système de conversion d'énergie (10) selon l'une quelconque des revendications 1 à 7 dans lequel les tuiles de base (112) sont formées pour fournir une isolation thermique à la structure de cadre de toit.

9. Système de conversion d'énergie (10) selon l'une quelconque des revendications 1 à 8 comprenant de plus un système hydroélectrique (200) configuré pour convertir l'énergie cinétique provenant de l'eau qui s'écoule de la portion du toit en énergie électrique.

10. Système de conversion d'énergie (10) selon la revendication 9 dans lequel le système hydroélectrique (200) comprend une ou plusieurs gouttières (220) et tuyaux de descente (228) et une ou plusieurs turbines à eau (216) dans lequel les gouttières (220) et les tuyaux de descente (228) sont disposés pour recueillir la pluie qui s'écoule de la portion de la structure de cadre de toit (14) pour produire un flux d'eau qui entraîne la ou chaque turbine à eau (216).

11. Système de conversion d'énergie (10) selon l'une quelconque des revendications 1 à 10 comprenant un système de conversion d'énergie éolienne (300) ayant une ou plusieurs turbines à vent (312) supportées par la structure de cadre de toit (14) qui convertissent l'énergie cinétique d'une masse d'air en déplacement en énergie électrique.

12. Système de conversion d'énergie (10) selon la revendication 11 dans lequel le système de conversion d'énergie éolienne (300) comprend de plus une couverture (316) qui recouvre l'une des ou plusieurs turbines à vent (312) pour créer, ensemble avec la structure de cadre de toit (14), un tunnel de vent (328) qui dirige de l'air en déplacement pour monter sur la structure de cadre de toit (14) par l'une des ou plusieurs turbines à vent (312).

13. Système de conversion d'énergie (10) selon l'une quelconque des revendications 1 à 8 en combinaison avec la revendication 9 ou 10 et la revendication 11 ou 12 comprenant de plus un système de gestion d'énergie (20) qui reçoit et gère l'énergie électrique provenant de la pluralité des tuiles de conversion d'énergie solaire (100), du système hydroélectrique (200) et du système de conversion d'énergie éolienne (300).

14. Système de conversion d'énergie (10) selon la revendication 13 dans lequel le système de gestion d'énergie (20) comprend une connexion (30, 32) vers une grille d'alimentation en électricité et est configuré pour gérer un flux à deux directions d'énergie électrique entre le système de conversion d'énergie et la grille d'alimentation.

15. Système de conversion d'énergie (10) selon la revendication 13 ou 14 dans lequel le système de gestion d'énergie (20) comprend un appareil de stockage d'énergie électrique, le système de gestion d'énergie (20) étant configuré pour fournir de l'énergie électrique à la grille d'alimentation lorsque l'appareil de stockage d'électricité est à l'état complètement chargé et reliant la grille d'alimentation à l'appareil de stockage d'électricité lorsque l'appareil de stockage d'électricité a un niveau de charge en dessous d'un niveau de seuil.
